# EUROPEAN PATENT APPLICATION

(11) **EP 4 625 109 A1**
(43) Date of publication of application: **01.10.2025**
(21) Application number: 25167584.9
(22) Date of filing: 31.03.2025
(51) Int. Cl.: G06F 1/20

(54) **HASH ASSEMBLY AND AIR-COOLED SERVER**

(30) Priority: 29.03.2024 CN 202410377047
(71) Applicant: Bitdeer Semiconductor Technology PTE. LTD., 049514 Singapore (SG)
(72) Inventor: YANG, Senfeng, 049514 Singapore (SG); LI, Weiguo, 049514 Singapore (SG)
(74) Representative: Wang, Bo

(57) **Abstract**

The present invention provides a hash assembly and an air-cooled server. The hash assembly comprises a hash board and a heat dissipation assembly fixedly connected to the hash board, a surface of the hash board is provided with a plurality of chip columns, each of the chip columns comprises a plurality of chips arranged in a direction of the heat dissipation channel, and the chips in each of the chip columns are arranged from the air ingress end to the air egress end in a dense-to-sparse manner; the heat dissipation assembly comprises at least one first heat sink and a base plate, the base plate has first surface and second surface opposite to each other, the first heat sink is in direct contact with the first surface, and the hash board is in direct contact with the second surface; the heat dissipation assembly further comprises a plurality of heat spreaders which are embedded in the base plate at a side of the base plate away from the hash board, and positions and number of the heat spreaders all correspond one to one with those of the chip columns. The hash assembly and the air-cooled server according to the present invention enable good temperature uniformity of chips during operation.

## Description

### FIELD

The present invention relates to the field of heat dissipation of hash boards, and particularly to a hash assembly and an air-cooled server.

### BACKGROUND

Demands for computation of a server for acquiring virtual currency are massive, and hundreds even thousands of chips usually need to be provided on a hash board to satisfy the demands for computation. However, chips will generate a lot of heat in a case of long-time operation, which causes the temperature in the space where the hash board lies is very high. In the prior art, the temperature in the space is up to 100+°C. However, if electronic elements such as chips operate at a high temperature in a long term, the service life of such electronic elements will be shortened and faults of machines are prone to occur. Therefore, the hash board generally needs to be provided with a dedicated heat sink to cool the hash board to reduce the temperature in the space where the hash board is located.

In conventional heat dissipation solutions of the hash board, a heat sink is usually fixed at a side of the hash board not provided with elements to absorb the heat in time, then the heat of the heat sink is taken away via a ventilation device such as a fan. However, since the temperature of the air just entering through an air inlet is low, the effect of cooling the dedicated chips near the air inlet is good. Since the air close to the air outlet has already absorbed a lot of heat, the effect of cooling the chips close to the air outlet is relatively poor. As a result, a temperature difference of the chips on the same hash board is large (even more than 10°C), and the temperature uniformity of the chips is poor, which is undesirable for those skilled in the art.

### SUMMARY

Based on the present state of the art, a main object of the present invention is to provide a hash assembly enabling a better chip temperature uniformity, and an air-cooled server.

The present invention employs the following technical solutions to achieve the above object: a hash assembly, comprising a hash board and a heat dissipation assembly fixedly connected to the hash board, one end of the hash board being an air ingress end and the other opposite end of the hash board being an air egress end, and a heat dissipation channel being formed between the air ingress end and the air egress end; a surface of the hash board is provided with a plurality of chip columns, each of the chip columns comprises a plurality of chips arranged in a direction of the heat dissipation channel, and the chips in each of the chip columns are arranged from the air ingress end to the air egress end in a dense-to-sparse manner;
the heat dissipation assembly comprises at least one first heat sink and a base plate, the base plate has first surface and second surface opposite to each other, the first heat sink is in direct contact with the first surface, and the hash board is in direct contact with the second surface;
the heat dissipation assembly further comprises a plurality of heat spreaders which are embedded in the base plate at a side of the base plate away from the hash board, and positions and number of the heat spreaders all correspond one to one with those of the chip columns.

Preferably, the heat spreaders are heat pipes, a plurality of mutually independent receiving grooves are provided on the first surface of the base plate, and the heat spreaders are fixed in the receiving grooves; positions and number of the receiving grooves all correspond one to one with those of the chip columns;
the base plate is fixed with the first heat sink by soldering;
the heat spreaders are fixed in the receiving grooves by a solder; a surface of the heat spreader close to the first heat sink is flush with the first surface; or the surface of the heat spreader close to the first heat sink is lower than the first surface, and a surface of the solder in the receiving groove is flush with the first surface.

Preferably, a plurality of raised strips are provided on a side of the base plate close to the hash board;
a surface of the raised strip close to the hash board is formed as the second surface, and the chips on the hash board directly contact the second surface and/or contact the second surface via a thermally conductive material;
a height difference of the second surface is less than 0.1 mm;
the thermally conductive material is one or more of a thermally conductive silicone grease, a thermally conductive gel or a thermally conductive pad.

Preferably, the hash assembly comprises a fixing member, a spring and a locking member, one end of the fixing member running through the spring, the first heat sink, the base plate and the hash board and being locked with the locking member;
Between adjacent ones of the raised stripes run through at least one said fixing member.

Preferably, the first heat sink comprises a first plate body and first fins extending in a heat dissipation and ventilation direction, the first fins being arranged at equal intervals and fixedly connected to a surface of the first plate body, the base plate being fixed on the other surface of the first plate body;
the first fin comprise a first fin segment and a second fin segment integrally connected in the direction of the heat dissipation channel, a distance between an end of the first fin segment away from the first plate body and the first plate body gradually increasing in a direction from the air inlet to the air outlet; a distance between an end of the second fin segment away from the first plate body and the first plate body is constant, and the distance is equal to a maximum distance between the end of the first fin segment away from the first plate body and the first plate body;
there are no said chips in a vertical projection region of a region occupied by the first fin segment on the hash board.

Preferably, an end of the first fin segment away from the first plate body is an inclined surface which is inclined at an angle in a range of 30°-60° with respect to the first plate body; a minimum distance between the end of the first fin segment away from the first plate body and the first plate body is 0.

Preferably, the hash assembly further comprises a second heat sink secured to a surface of the hash board away from the first heat sink;
positions of top surfaces of the first heat sink and the second heat sink are lower than a position of the top surface of the hash board, and positions of bottom surfaces of the first heat sink and the second heat sink are higher than a position of the bottom surface of the hash board.

Preferably, the hash assembly further comprises a second heat sink, the second heat sink comprises a second plate body and second fins extending in the heat dissipation and ventilation direction, the second fins being arranged at equal intervals and fixedly connected to a surface of the second plate body, and the hash board being fixed on the other surface of the second plate body;
the second fin comprises a first fin section and a second fin section integrally connected in the direction of the heat dissipation channel, a distance between an end of the first fin section away from the second plate body and the second plate body gradually increasing in the direction from the air inlet to the air outlet; a distance between an end of the second fin section away from the second plate body and the second plate body is constant, and the distance is equal to a maximum distance between the end of the first fin section away from the second plate body and the second plate body;
there are no said chips in a region of the hash board corresponding to the first fin section.

Preferably, the heat spreader is a heat pipe, and is a plate-shaped body formed by flatting a cylindrical heat pipe which is placed in a receiving groove provided on the base plate;
the heat transferred from a maximum temperature to a minimum temperature of the heat spreader Qmax≥30W; when the heat is Qmax, a temperature difference ΔT between an evaporation end and a condensation end is ΔT ≤3°C.

The present invention further provides an air-cooled server comprising a chassis and the hash assembly as described above, the hash assembly being received in the chassis.

Preferably, a sliding groove is disposed on a top and a bottom of the chassis, respectively, and the fixing and sliding of the hash assembly in the chassis is achieved in a way that the top and bottom of the hash board are engaged in the sliding grooves;
a distance between adjacent said hash assemblies is greater than 2 mm; a gap exists between the top surface and bottom surface of the first heat sink and the top surface and bottom surface of the chassis, respectively.

The present invention provides the hash assembly and the air-cooled server. The chips in each chip column on the hash board are arranged in a dense-to-sparse manner from the air ingress end to the air egress end. Although the chips located close to the air inlet are densely arranged, since they are located close to the air inlet, air entering through the air inlet may better carry away heat from the chips. The chips close to the air outlet are arranged relatively sparsely; even though the temperature of air already rises when air moves to this position, since there is relatively less heat generated at this positon, the temperature of the chips at this position after heat dissipation is equal to or tends to be close to that of the chips located close to the air inlet after heat dissipation, and the chip temperature uniformity on the chip columns is better. The base plate is disposed between the first heat sink and the hash board, the heat spreaders whose positions and number corresponding one to one with the chip columns are embedded in the base plate, and the heat spreaders may effectively balance the temperature difference on the chip columns so that the temperature uniformity of the chips is better.

Other advantageous effects of the present invention will be described by introducing specific technical features and technical solutions in specific embodiments. Those skilled in the art can understand the advantageous technical effects resulting from the technical features and technical solutions by reading through the introduction of these technical features and technical solutions.

### BRIEF DESCRIPTION OF THE DRAWINGS

Preferred embodiments of the present invention will be described hereinafter with reference to the following figures. In the figures,
FIG. 1 is a perspective view of a hash assembly according to an embodiment of the present invention.
FIG. 2 is a schematic view of air ingress and air egress of a hash assembly according to an embodiment of the present invention.
FIG. 3 is a schematic view of a hash assembly with a fan according to an embodiment of the present invention.
FIG. 4 and FIG. 5 are exploded views of a hash assembly at different angles according to the embodiment of the present invention.
FIG. 6 is a schematic view of a first surface of a base plate included in a hash assembly according to an embodiment of the present invention.
FIG. 7 is an enlarged view of portion A of FIG. 4.
FIG. 8 is a schematic view of a second surface of a base plate included in a hash assembly according to an embodiment of the present invention.
FIG. 9 is a schematic view of a hash assembly as viewed from an air ingress end according to an embodiment of the present invention.
FIG. 10 is a top view of a hash assembly according to an embodiment of the present invention.
FIG. 11 is a top view of a first heat sink included in a hash assembly according to an embodiment of the present invention.
FIG. 12 is a perspective view of an air-cooled server according to an embodiment of the present invention.
FIG. 13 is a perspective view of a hash module included in an air-cooled server according to an embodiment of the present invention.
FIG. 14 is a perspective view of a chassis included in an air-cooled server according to an embodiment of the present invention.
FIG. 15 is a diagram of a heat dissipation simulation effect in which a hash board directly uses a first heat sink to dissipate heat in the prior art.
FIG. 16 is a diagram of a heat dissipation simulation effect in which a hash board uses a heat dissipation solution of the present application to dissipate heat.
FIG. 17 and FIG. 18 are a diagram of a heat dissipation simulation effect in which a first heat dissipation solution is used to dissipate heat, and a diagram of heat flux simulation on heat pipe surface.
FIG. 19 and FIG. 20 are a diagram of a heat dissipation simulation effect in which a second heat dissipation solution is used to dissipate heat, and a diagram of heat flux simulation on a heat pipe surface.

### Description of Reference Numerals:

2a Hash module; 2 Hash assembly; 21 Hash board; 211 Chip column; 21a Air ingress end; 21b Air egress end; 22 Heat dissipation assembly; 221 First heat sink; 2211 First plate body; 2212 First fin; 2213 First fin segment; 2214 Second fin segment; 223 Base plate; 223a First surface; 223b Second surface; 2231 Receiving groove; 2233 Raised strip; 225 Heat spreader; 227 Second heat sink; 2271 Second plate body; 2272 Second fin; 2273 First fin section; 2274 Second fin section; 229 Fixing assembly; 2291 Fixing member; 2293 Spring; 41 First fan; 42 Second fan; 3 Chassis; 31 Sliding groove; 311 First sub-sliding groove; 312 Second sub-sliding groove; 2b Power supply module; 2c Control module.

### DETAILED DESCRIPTION OF EMBODIMENTS

The present invention will be described based on embodiments, but the present invention is not only limited to these embodiments. In the following detailed depictions of the present invention, some specific details are presented in detail. In order to avoid confusing the spirit of the present invention, well-known methods, processes, procedures and elements are not described in detail.

**In** addition, those having ordinary skill in the art should appreciate that the figures are provided herein for illustrative purposes and are not necessarily drawn to scale.

Unless the context clearly requires otherwise, words such as "comprise" and "contain" throughout in the whole description and the claim set should be understood as having the meaning of containing rather than exclusive or exhaustive, i.e., as having the meaning of "including but not limited to".

In the description of the present invention, it is to be understood that the terms "first", "second" etc. are used for descriptive purposes only and are not to be understood as indicating or implying relative importance. In addition, in the description of the present invention, the meaning of "a plurality of" means two or more unless otherwise specified.

The present invention provides a hash assembly, comprising a hash board and a heat dissipation assembly fixedly connected to the hash board, one end of the hash board being an air ingress end and the other opposite end of the hash board being an air egress end, and a heat dissipation channel being formed between the air ingress end and the air egress end; a surface of the hash board is provided with a plurality of chip columns, each of the chip columns comprises a plurality of chips arranged in a direction of the heat dissipation channel, and the chips in each of the chip columns are arranged from the air ingress end to the air egress end in a dense-to-sparse manner.

The heat dissipation assembly comprises at least one first heat sink and a base plate, the base plate has first surface and second surface opposite to each other, the first heat sink is in direct contact with the first surface, and the hash board is in direct contact with the second surface.

The heat dissipation assembly further comprises a plurality of heat spreaders which are embedded in the base plate at a side of the base plate away from the hash board, and positions and number of the heat spreaders all correspond one to one with those of the chip columns.

The present invention further provides an air-cooled server comprising a chassis and the hash assembly as described above, the hash assembly being received in the chassis.

The hash assembly and the air-cooled server according to the present invention will be described in detail below.

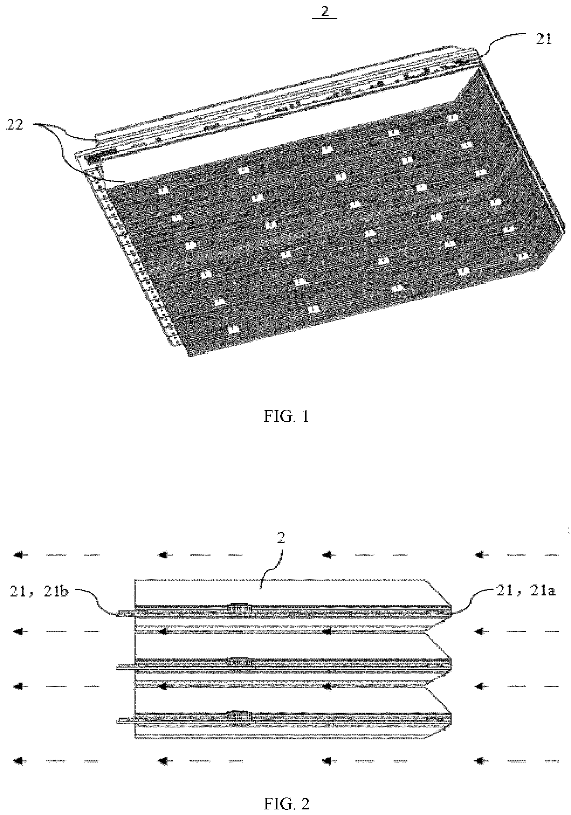

Referring to FIG. 1 through FIG. 3, the present invention provides a hash assembly 2 which is hardware for providing computing power to a server.

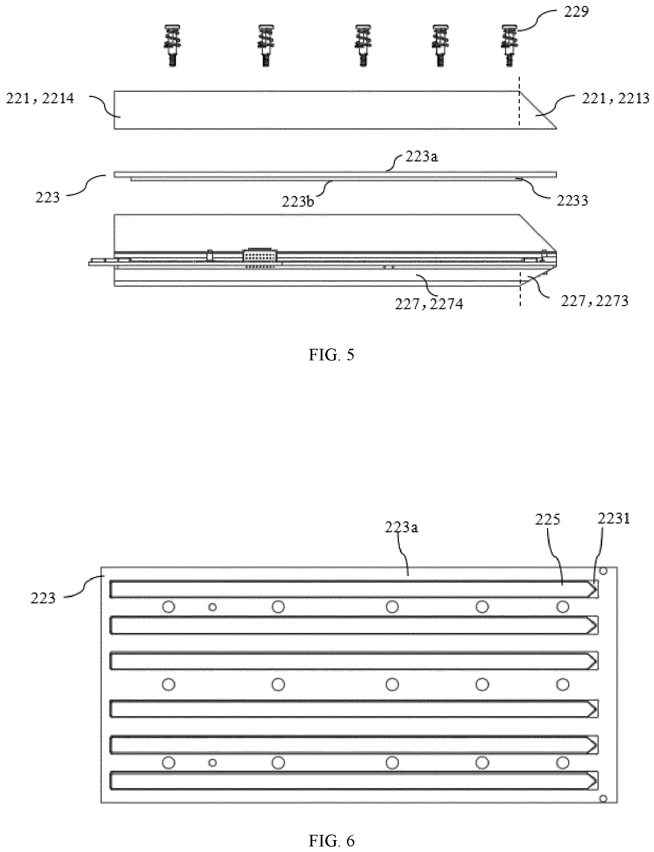

The hash assembly 2 comprises a hash board 21 and a heat dissipation assembly 22, wherein the hash board 21 is a circuit board, the hash board 21 is provided with a plurality of chip columns 211 (the reference number can be seen in FIG. 5), and the chip columns 211 each comprise a plurality of chips arranged on the same straight line. Cooperation between chips accomplishes different computing tasks. The heat dissipation assembly 22 is fixed with the hash board 21 and dissipates heat from the hash board 21.

The hash board 21 has a first end 21a and a second end 21b opposite to each other, the first end 21a is an air ingress end, the second end 21b is an air egress end, and a heat dissipation channel is formed between the first end 21a and the second end 21b. Specifically, air enters from the air ingress end and exits from the air egress end, thereby carrying heat away from the hash assembly 2.

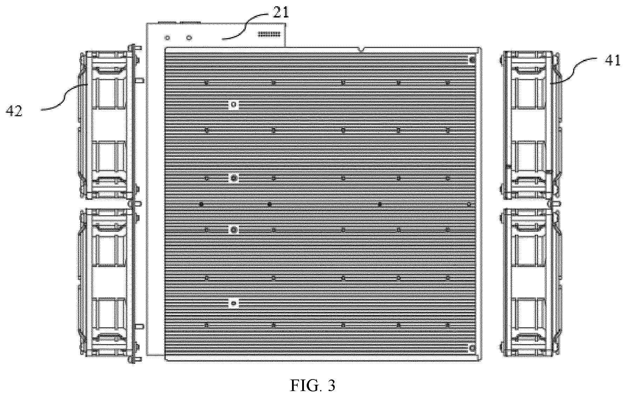

Referring to FIG. 3, as a specific embodiment, a first fan 41 is provided at the first end 21a of the hash board 21, and a second fan 42 is provided at the second end 21b of the hash board 21. The first fan 41 draws in air from the air ingress end, the air passes through the heat dissipation channel, and the second fan 42 discharges the air out of the air egress end.

As an embodiment, each chip column 211 comprises a plurality of chips arranged in the direction of the heat dissipation channel.

As an embodiment, the chips in each of the chip columns 211 are arranged from the air ingress end to the air egress end in a dense-to-sparse manner, that is, the chips close to the first end 21a of the hash board 21 are arranged densely, and the chips close to the second end 21b of the hash board 21 are arranged sparsely. According to such an arrangement, although the chips close to the air ingress end are arranged densely, since they are located at the air ingress end, air entering through the air ingress end can carry heat from the chips very well; in contrast, the chips close to the air egress end are arranged relatively sparsely; even though the temperature of air already rises when air moves to the position, since less heat is generated at the position, the temperature of chips at the position after being cooled is equal to or tends to be close to the temperature of the chips at the air ingress end after being cooled, so that the uniformity of the temperature of the chips in the chip columns is better.

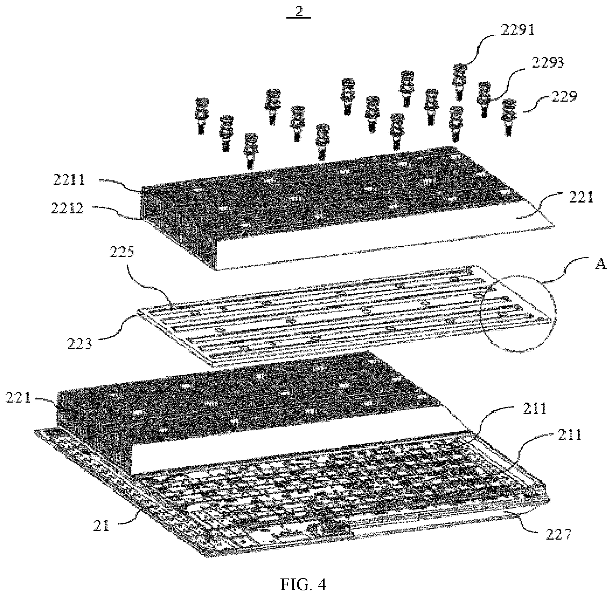

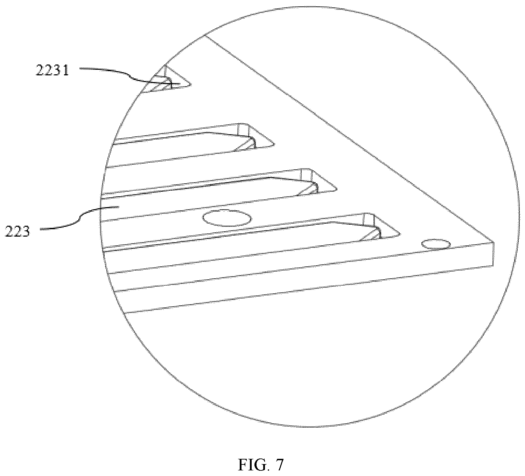

Referring to FIG. 4 through FIG. 7, as viewed from the angle shown in FIG. 4, the heat dissipation assembly 22 comprises, from top to bottom, a plurality of first heat sinks 221, a base plate 223 where heat spreaders 225 are embedded, and a second heat sink 227, wherein the base plate 223 has opposite first and second surfaces 223a and 223b, the first heat sinks 221 are in direct contact with the first surface 223a, and the hash board 21 is in direct contact with the second surface 223b.

The heat spreaders 225 are embedded in the base plate 223 on the side of the base plate 223 away from the hash board 21. The positions and number of the heat spreaders 225 all correspond one to one with those of the chip columns 211, that is to say, a projection of each heat spreader 225 on the hash board 21 covers one chip column 211.

It may be appreciated that the heat spreaders 225 are embedded in the base plate 223 on the side of the base plate 223 away from the hash board 21, that is to say, the heat spreaders 225 are not embedded in the base plate 223 on the side of the second surface 223b. Specifically, the heat spreaders 225 may be embedded in the base plate 223 from the side where the first surface 223a is located. Alternatively, the base plate 223 comprises a first sub-base plate and a second sub-base plate, opposite surfaces of the first sub-base plate and the second sub-base plate are both provided with grooves, and when the first sub-base plate and the second sub-base plate are fixed together, the grooves located on the first sub-base plate and the second sub-base plate are spliced to form a space for receiving the heat spreader 225. The present invention will be described by taking an example in which the heat spreader 225 is embedded in the base plate 223 from the first surface 223a side. A plurality of mutually independent receiving grooves 2231 are provided on the first surface 223a of the base plate 223, and the heat spreaders 225 are fixed in the receiving grooves 2231; the positions and number of the receiving grooves 2231 all correspond one to one with those of the chip columns 211.

Since the heat spreaders 225 are embedded in the base plate 223 on the side of the base plate 223 away from the hash board 21, the presence of the heat spreaders 225 does not affect the contact between the base plate 223 and the chips, thereby avoiding that poor flatness of the surfaces of the heat spreaders 225 (the heat spreaders 225 manufactured by the currently-existing processes have poor flatness at the surface of the heat pipe, and a height difference at the surface is usually greater than 0.5mm) causes the likelihood to occurrence of damages to chips due to uneven pressure when the base plate contacts the chips during mounting. A thermally conductive material, such as a thermally conductive silicone, typically needs to be filled between the heat spreaders 225 and the chips to avoid the crushing of the chips when the heat spreaders 225 directly contact the chips. However, since the heat spreaders 225 have poor flatness, the thermally conductive silicone has a large thickness, and furthermore, the heat conduction performance of the thermally conductive silicone is much lower than that of the heat spreaders 225, the base plate 223 and the first heat sink 221 made of a metal material (generally copper or aluminum). Therefore, use of this solution will greatly affect the heat dissipation effect. The heat pipe is separated from the chips by only a layer of thermally conductive silicone, the heat pipe surface has a high heat flux density, and the heat pipe faces a high risk of dry burning.

As an embodiment, the base plate 223 is fixed to the first heat sink 221 by soldering. The base plate 223 and the first heat sink 221 are soldered together by a solder (e.g., a solder paste), so that the first heat sink 221 and the base plate 223 are in close contact with each other with a high heat transfer efficiency.

As an embodiment, the heat spreader 225 is fixed in the receiving groove 2231 by the solder, and a surface of the heat spreader 225 close to the first heat sink 221 is flush with the first surface 223a; alternatively, the surface of the heat spreader 225 close to the first heat sink 221 is lower than the first surface 223a, and the surface of the solder in the receiving groove 2231 is flush with the base plate 223 close to the first surface 223a. It may be appreciated that the surface of the heat spreader 225 is flush with the first surface 223a or the solder is flush with the first surface 223a in order that the first surface 223a forms a complete flat surface so that there is no or almost no air gap between the base plate 223 and the first heat sink 221 for more efficient heat transfer.

As an embodiment, the heat spreader 225 is a heat pipe. The heat pipe is of a hollow structure, and the interior of the heat pipe contains a liquid which may be converted between a liquid phase and a vapor phase, thereby performing phase-change heat transfer to maintain or tend to maintain the temperature in the heat pipe at the same level. Therefore, the heat pipe can well balance the temperatures of chips on the chip column 211, and may effectively bring the heat from a high-temperature region to a low-temperature region, to make the temperatures of chips in the chip column 211 more uniform.

It may be appreciated that the temperature at the air egress end is high because when air moves to the air egress end, the heat that can be carried away by air is limited. In the case of regular or irregular arrangement of chips, the heat pipes are embedded in the base plate 223, so that the temperatures of the hash board 21 adjacent to the air ingress end and air egress end tend to be close to each other, thereby ensuring the temperature uniformity of the whole hash board 21.

As an embodiment, the heat pipe is a plate-shaped body whose length and width are both greater than the length and width of the chip column 211. In a case where the heat pipe corresponds to the chip column 211 in position, the heat on the chips may be absorbed by the heat pipe. The thickness of the heat pipe is uniform in a direction perpendicular to a planar extension direction of the base plate 223.

As an embodiment, the heat spreader 225 is formed in a way of providing a cylindrical heat pipe whose diameter is less than a width of the receiving groove 2231 and greater than a depth of the receiving groove 2231 and whose length is equal to or slightly less than that of the receiving groove 2231, placing the cylindrical heat pipe into the receiving groove 2231, applying a force to the heat pipe to flatten the heat pipe so that the heat pipe fills or almost fills the receiving groove 2231. As an embodiment, the chip is an 8 mm chip, and a cylindrical heat pipe with a diameter of 6 mm is flattened to 2 mm thick and 8.5 mm wide, to obtain the heat pipe in the present application.

As an embodiment, the heat transferred from a maximum temperature to a minimum temperature of the heat pipe in the present application Qmax≥30W. When the heat is Qmax, a temperature difference ΔT between an evaporation end and a condensation end is ΔT ≤ 3°C, to enable a better heat spreading effect of the heat spreader 225.

As an embodiment, a space between the heat pipe and an inner wall of the receiving groove 2231 is filled with a solder.

As an embodiment, a gap exists between an end of the heat pipe and the inner wall of the receiving groove 2231, and the gap is filled with a solder.

It will be appreciated that the base plate 223 is a plate-shaped member which, as a whole, also facilitates heat exchange between different positions and helps maintain temperature uniformity across the hash board 21.

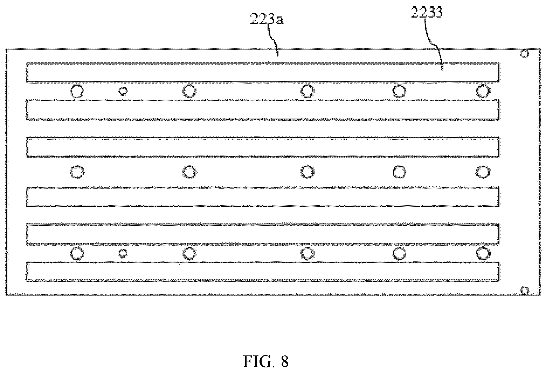

Referring to FIG. 5 and FIG. 8, a plurality of raised strips 2233 are provided on a surface of the base plate 223 close to the hash board 21, the raised strips 2233 are positioned corresponding to the chips, and the base plate 223 directly contacts the chips through the raised strips 2233. The surface of the raised strip 2233 directly contacting the hash board 21 is the second surface 223b.

It may be appreciated that the raised strip 2233 is a protrusion formed on the surface of the base plate 223, the raised strip 2233 is disposed corresponding to the position of the chip, and the base plate 223 directly contacts the chips through the raised strip 2233. Due to a large number of chips on the hash board 21, in a process of fixing the hash board 21 with the heat dissipation assembly 22, the chips will be crushed as locally receiving an excessively large force in a case where the surface of the element in contact with the chips has a poor flatness. The base plate 223, as a plate-shaped body, has a large area. If the entire surface of the base plate 223 adjacent to the hash board 21 is set as a plane, it is difficult to ensure its flatness in terms of process. Therefore, when the base plate 223 is fixed with the hash board 21, the chips are prone to damages. In the present application, the surface of the base plate 223 is provided with raised strips 2233 which are disposed corresponding to the chips and whose sizes may be much smaller than the area of the whole base plate 223. During manufacturing, it is easier to ensure the flatness of the surface of the raised strips 2233 and reduce or eliminate the possibility of damages of the chips.

As an embodiment, a height difference of the surface of the raised strip 2233 in direct contact with the chips is less than 0.1 mm. Preferably, the height difference of the surface of the raised strip 2233 in direct contact with the chips is less than or equal to 0.05 mm.

In some embodiments, a thermally conductive material is disposed between the second surface 223b and the chips. The thermally conductive material may be one or more of a thermally conductive silicone grease, a thermally conductive gel or a thermally conductive pad. The height differences between the raised strips 2233 and the chips at different positions may be filled with the thermally conductive material. The thermally conductive material will be filled between part of the second surface 223b and the chips, or between the entire second surface 223b and the chips. Since the raised strip 2233 itself has a better flatness, the thickness of the thermally conductive material is thin and has less influence on heat dissipation (the thicker the thermally conductive material is, the worse the heat dissipation effect is).

It may be appreciated that the chips directly contact the second surface 223b and/or contact the second surface 223b via the thermally conductive material.

In some embodiments, the number of raised strips 2233 is kept equal to that of heat spreaders 225 and receiving grooves 2231. That is, in some embodiments, the raised strips 2233 may be disposed corresponding to the chip columns 211, and one raised strip 2233 may be correspondingly provided for one chip column 211, which better facilitates the conduction of heat of the chip column 211 and the balance of the heat by the heat spreader 225. In other embodiments, the raised strips 2233 may also be provided corresponding to the number of chips, for example, one chip corresponds to one raised strip 2233, or a plurality of chips correspond to one raised strip 2233.

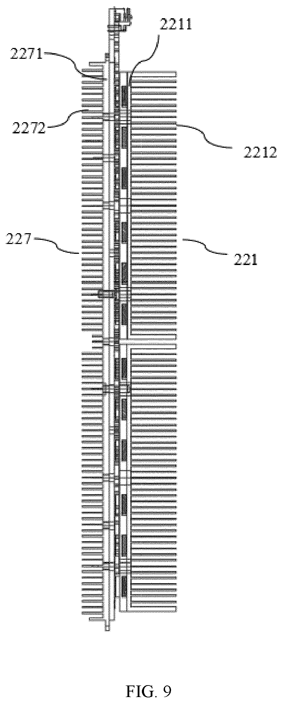

Referring to FIG. 9 through FIG. 11, as an embodiment, the first heat sink 221 comprises a first plate body 2211 and first fins 2212 extending in a heat dissipation and ventilation direction, the first fins 2212 being arranged at equal intervals and fixedly connected to a surface of the first plate body 2211, the base plate 223 being fixed on the other surface of the first plate body 2211; the first fin 2212 comprises a first fin segment 2213 and a second fin segment 2214 integrally connected in the direction of the heat dissipation channel, a distance between an end of the first fin segment 2213 away from the first plate body 2211 and the first plate body 2211 gradually increasing in a direction from the air inlet to the air outlet (namely, forming an inclined surface); a distance between an end of the second fin segment 2214 away from the first plate body 2211 and the first plate body 2211 is constant, and the constant distance is equal to a maximum distance between the end of the first fin segment 2212 away from the first plate body 2211 and the first plate body 2211.

As one embodiment, there are no chips in a vertical projection region of a region occupied by the first fin segment 2213 on the hash board 21. The region occupied by the first fin segment 2213 refers to a region enclosed by an outer contour of the first fin segment 2213, and comprises a gap region between the first fin segments 2213. The vertical projection region of the region occupied by the first fin segment 2213 on the hash board 21 is used for providing wirings, i.e., for chip wirings. The chips are all located in a vertical projection region of a region occupied by the second fin segment 2214 on the hash board 21. The region occupied by the second fin segment 2214 refers to a region enclosed by an outer contour of the second fin segment 2214, and comprises a gap region between the second fin segments 2214.

Since the second fin segment 2214 has a complete height with respect to the first fin segment 2213, its heat dissipation area is large, and the heat dissipation area of the chips is ensured. The first fin segment 2213, disposed corresponding to the wiring region, does not reduce the heat dissipation effect of the chips, and the presence of the first fin segment 2213 increases the heat dissipation area and facilitates heat dissipation. In addition, the presence of the first fin segment 2213 may effectively prevent dust from clogging the gaps between the first fins 2212. When a large amount of dust enters through the air inlet, the dust is blown onto the inclined surface, and the inclined surface guides the dust to move toward the side of the first heat sink 221 away from the hash board 21, to discharge out the large amount of dust by means of the force of the wind. The fine dust entering through the air ingress end is directly discharged from the gaps between the first fins 2212. The provision of the inclined surface also helps guide the incoming air in order to provide a better heat dissipation effect. If an end face of the first heat sink 221 adjacent to the air intake end is provided as a vertical surface rather than the inclined surface in the present application, the vertical surface plays a certain role of blocking air; when a large amount of dust enters, it is apt to form blockages at the end face, blocking the air flow, so that the heat of the chips cannot be taken away promptly and effectively. The structural design of the first fins 2212 in the present application solves this technical problem. Furthermore, the design of the inclined surface of the first fin segment 2213 may reduce the obstruction of the system, and the airflow is guided by the inclined surface to reduce the turbulence, so that the noise is reduced and the auditory comfort of the human ears is improved.

As an embodiment, an end of the first fin segment 2213 away from the first plate body 2211 is an inclined surface which is inclined at an angle in a range of 30°-60° with respect to the first plate body 2211; a minimum distance between the end of the first fin segment 2213 away from the first plate body 2211 and the first plate body 2211 is 0. Under this parameter, the inclined surface has a better air guiding effect, a better dust guiding effect and a better noise reduction effect, so that the heat dissipation effect of the chips is also very good.

As an embodiment, the inclined surface may be a plane or an arcuate surface. When the inclined surface is a plane, an inclination angle is preferably 45°; at this angle, the air guiding effect, dust guiding effect and noise reduction effect of the inclined surface are very good, so that the heat dissipation effect of the chips is also very good.

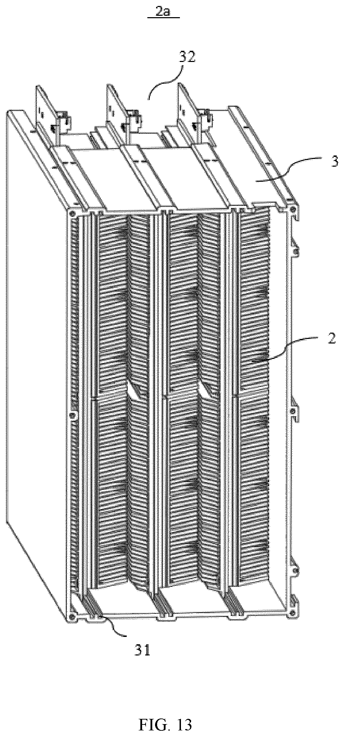

As an embodiment, a distance between the end of the first heat sink 221 away from the base plate 223 and an adjacent element (the chassis 3 and/or the hash assembly 2) is greater than or equal to that between the adjacent first fins 2212. Specifically, the distance between the hash assemblies 2 is greater than or equal to that between the adjacent first fins 2212 to help discharge a large amount of dust through the gap between the hash assemblies 2. The distance between the hash assembly 2 on the rightmost side in FIG. 13 and the chassis 3 is greater than or equal to that between the adjacent first fins 2212.

As an embodiment, there are a plurality of first heat sinks 221 above the base plate 223. As shown in FIG. 4, there are two first heat sinks 221 above the base plate 223. It may be appreciated that the number of the first heat sinks 221 may be set as needed to satisfy the heat dissipation demands of the hash board 21. One first heat sink 221 may also be provided as long as it can be sized to cover at least the region where the chips are located.

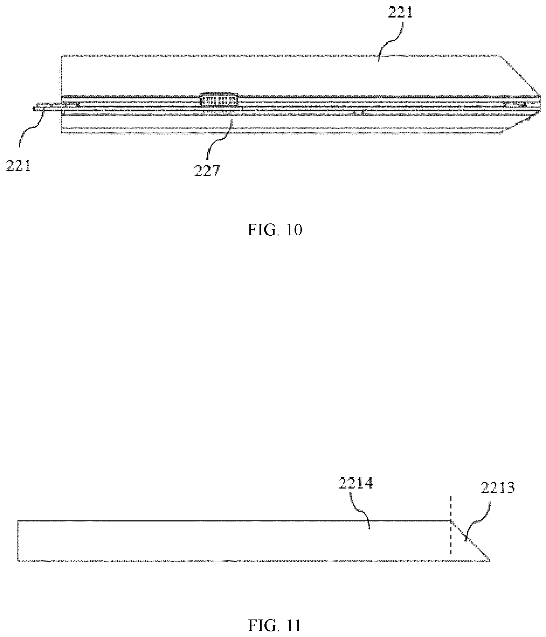

Further referring to FIG. 9 and FIG. 10, the hash assembly 2 further comprises a second heat sink 227 secured to a surface of the hash board 21 away from the first heat sink 221.

Positions of top surfaces of the first heat sink 221 and the second heat sink 227 are lower than the position of the top surface of the hash board 21, and positions of bottom surfaces of the first heat sink 221 and the second heat sink 227 are higher than the position of the bottom surface of the hash board 21. In this way, the heat dissipation channels can be conveniently formed above the top surfaces and below the bottom surfaces of the first heat sink 221 and the second heat sink 227, and the heat dissipation effect can be improved.

As an embodiment, the structure of the second heat sink 227 may be identical to that of the first heat sink 221, and the positional relationship between the second heat sink 227 and the chips on the hash board 21 may be identical to that between the first heat sink 221 and the chips on the hash board 21. Likewise, the second heat sink 227 comprises a second plate body 2271 and second fins 2272 extending in the heat dissipation and ventilation direction, the second fins 2272 being arranged at equal intervals and fixedly connected to a surface of the second plate body 2271, and the hash board 21 being fixed on the other surface of the second plate body 2271; the second fin 2272 comprises a first fin section 2273 and a second fin section 2274 integrally connected in the direction of the heat dissipation channel, a distance between an end of the first fin section 2273 away from the second plate body 2271 and the second plate body 2271 gradually increasing in the direction from the air inlet to the air outlet; a distance between an end of the second fin section 2274 away from the second plate body 2271 and the second plate body 2271 is constant, and the distance is equal to a maximum distance between the end of the first fin section 2273 away from the second plate body 2271 and the second plate body 2271; a region of the hash board 21 corresponding to the region occupied by the first fin section 2273 contains no chips and the region is used for wiring. The chips are all located in the region of the hash board 21 corresponding to the region occupied by the second fin section 2274.

As an embodiment, the second heat sink 227 may be omitted.

As an embodiment, the first heat sink 221, the base plate 223 and the second heat sink 227 are all made of an aluminum material, and the material of the surface of the heat pipe is copper. All the materials have a good heat conduction performance.

As an embodiment, no chips are provided on the surface of the hash board 21 away from the base plate 223, and the second heat sink 227 may be directly fixed to this surface. It will be appreciated that chips may also be provided on the surface of the hash board 21 away from the base plate 223, and the base plate 223 with the heat spreaders 225 embedded therein as described above may also be provided between the second heat sink 227 and the chips, and the base plate 223 may contact the chips via the raised strips 2233.

As an embodiment, when the heat of chips is mainly dissipated from a front side, the size of the first heat sink 221 is larger than that of the second heat sink 227 in a direction perpendicular to the hash board 21. That is, in a case where the first plate body 2211 and second plate body 2271 has the same thickness, a protrusion height of the first fin 2212 relative to the first plate body 2211 is greater than that of the second fin 2272 relative to the second plate body 2271. Therefore, providing the first heat sink 221 with a larger heat dissipation area is more advantageous in providing good heat dissipation for the chips, and in maintaining thermal balance on both sides of the hash board 21.

As an embodiment, the heat dissipation assembly 22 further comprises a fixing assembly 229 which includes a fixing member 2291 and a locking member (not shown), wherein the fixing member 2291 runs through the first heat sink 221, the base plate 223, the hash board 21 and the second heat sink 227 and is locked with the locking member.

As an embodiment, an end of the fixing member 2291 away from the locking member is sleeved with an elastic member, and one end of the fixing member 2291 runs through a spring 2293, the first heat sink 221, the base plate 223 and the hash board 21, and is locked with the locking member, so that the fixing between the fixing member 2291 and the locking member is elastic fixing; in the case where the fixing is reliable, the electronic device is prevented from damages due to excessive pressure between elements.

As an embodiment, the fixing member 2291 is a screw and the locking member is a nut. The elastic member is the spring 2293.

As an embodiment, between the adjacent raised strips 2233, the base plate 223 is provided with a through hole through which the fixing member 2291 passes. At least one fixing member 2291 passes through between the raised strips 2233 to ensure that the chips are in close contact with the raised strips 2233, so that a good heat conduction effect may be obtained.

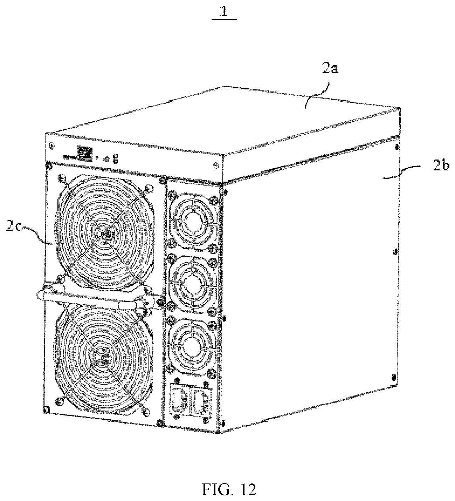

Referring to FIG. 12 through FIG. 14, the present invention further provides a server 1 for acquiring virtual money. The miner server 1 comprises a hash module 2a, a power supply module 2b and a control module 2c, wherein the hash module 2a and the power supply module 2b are arranged side by side and fixedly connected to each other, and the control module 2c is fixedly mounted on the top of the hash module 2a and the power supply module 2b. The hash module 2a provides a computing power for the server, a power supply is disposed in the power supply module 2b to provide electric energy for the server 1, and the control module 2c is used to control the operation of the server.

It may be appreciated that the server 1 is not limited to performing the mining of virtual currency, but may also perform data processing other than virtual currency mining.

It is to be understood that the relative positions of the hash module 2a, the power supply module 2b and the control module 2c may be adjusted, for example, the positions of the power supply module 2b and the hash module 2a are interchangeable, and the control module 2c may be provided only on the top of the hash module 2a, etc. In some embodiments, the hash module 2a, the power supply module 2b, and the control module 2c may be integrated together, e.g., a control element within the control module 2c may be integrated into the power supply module 2b or the control module 2c, an element in the power supply module 2b may be integrated directly into the hash module 2a, etc. It is to be understood that the relative positions between and the integration manners of the hash module 2a, the power supply module 2b and the control module 2c are not limited as long as the functions of the server can be realized.

Referring to FIG. 13, the hash module 2a comprises a chassis 3 and three hash assemblies 2 received in the chassis 3. It may be understood that the number of the hash assemblies 2 received in the chassis 3 may be adjusted as actually needed, and may be one or more (including two or more). The present invention is schematically illustrated with three hash assemblies 2 as an example.

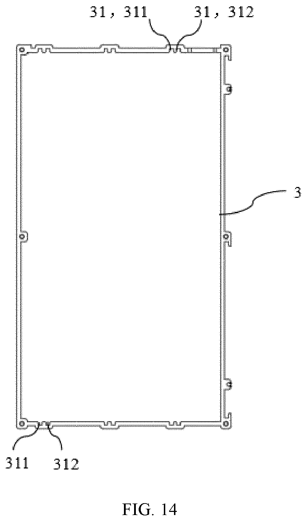

With reference to FIG. 14, a sliding groove 31 is disposed on the top and bottom of the chassis 3, and the number and positions of the sliding grooves 31 on the top correspond one to one with those on the bottom. During the mounting process, the bottom and the top of one end of the hash assembly 2 may be respectively engaged into the sliding grooves 31 at the bottom and the top of the chassis 3, and the hash assembly 2 is pushed so that it may move along the sliding grooves 31 to completely enter the chassis 3.

As an embodiment, each sliding groove 31 comprises a first sub-sliding groove 311 and a second sub-sliding groove 312 arranged in parallel with each other, and the first sub-sliding groove 311 and the second sub-sliding groove 312 are adapted to different hash assemblies 2 (such as hash assemblies 2 with different thicknesses). It will be appreciated that the second sub-sliding groove 312 may be omitted, i.e., the remaining first sub-sliding groove 311 is the sliding groove 31.

As an embodiment, in a case where a ratio of thickness (i.e., the dimension in the direction perpendicular to the hash board 21) of the first heat sink 221 to the second heat sink 227 is 2:1, the top and the bottom of the hash board 21 are located in the first sliding groove 31. In a case where the ratio of thickness of the first heat sink 221 to the second heat sink 227 is 1:1, the top and bottom of the hash board 21 are located in the second sliding groove 31. In this way, the chassis 3 may be applicable for the sliding and fixing of the hash assemblies 2 of different thicknesses in the chassis 3.

It may be understood that when a thermal resistance RJC (namely, the thermal resistance from a heat source junction to a packaging case of the chips) of the chips is much smaller than a thermal resistance RJB (namely, the thermal resistance from the heat source junction of the chip to the PCB board), heat is more easily dissipated from the front side of the chip, and then the thickness of the first heat sink 221 is set to be greater than the that of the second heat sink 227, and the heat dissipation effect can be more ensured. For example, the ratio of the thickness of the first heat sink 221 to the second heat sink 227 is set to be 2:1. Conversely, when heat is more easily dissipated from the back side of the chip, setting the thickness of the first heat sink 221 to be less than or equal to the that of the second heat sink 227 is more beneficial to guarantee the heat dissipation effect, for example, setting the ratio of thicknesses of the first heat sink 221 to the second heat sink 227 to be 1:1.

In some embodiments, part of the hash assembly 2 is located outside the chassis 3. Specifically, a recess 32 is provided at the top of the chassis 3, and part of the top of the hash assembly 2 protrudes out of the recess 32, to be conveniently electrically connected with a control element in the control module 2c. In some embodiments, the hash assembly 2 may also be fully received within the chassis 3, and the recess 32 facilitates wiring (e.g., a cable, FPC, or the like) between the control module 2c and the hash assembly 2.

It may be appreciated that the top and bottom of the hash assembly 2 located within the chassis 3 are received in the sliding grooves 31 to enable sliding and fixing of the hash assembly 2 within the chassis 3. It may be appreciated that the top or bottom of the hash assembly 2 in the present invention is located in the sliding groove 31, including a case that the top or bottom of the hash assembly 2 is partially or all located in the sliding groove 31.

As an embodiment, a distance between adjacent ones of the hash assemblies 2 is greater than or equal to 2 mm, to facilitate the heat dissipation of the hash assemblies 2.

As an embodiment, the top surface and the bottom surface of the hash assembly 2 located in the chassis 3 are received in the sliding grooves 31. Specifically, the hash assembly 2 is received in the sliding grooves 31 via the top surface and the bottom surface of the hash board 21 to achieve the fixation of the hash assembly 2 in the chassis 3. Specifically, the positions of the top surfaces of the first heat sink 221 and the second heat sink 227 are lower than the position of the top surface of the hash board 21, and the positions of the bottom surfaces of the first heat sink 221 and the second heat sink 227 are higher than the position of the bottom surface of the hash board 21. There is a distance between the hash board 21 and the top surface of the first heat sink 221 and the top surface of the second heat sink 227; there is a distance between the bottom surface of the hash board 21 and the bottom surface of the first heat sink 221 and the bottom surface of the second heat sink 227; furthermore, in the direction from the top surface to the bottom surface of the hash board 21, the sizes of the first heat sink 221 and said second heat sink 227 are smaller than that of the hash board 21, that is to say, the top surface and the bottom surface of the hash assembly 2 are the top surface and the bottom surface of the hash board 21. When the hash assembly 2 is received in the chassis 3, a gap exists between the top surface and bottom surface of each of the first heat sink 221 and second heat sink 227 and the chassis 3 so that air passes through the gaps to carry away the heat in the hash assembly 2.

As an embodiment, the thickness (namely, the dimension in a direction perpendicular to the hash board 21) of the first heat sink 221 is greater than that (namely, the dimension in a direction perpendicular to the hash board 21) of the second heat sink 227; in the direction from the top surface to the bottom surface of the hash board 21, the size of the first heat sink 221 is less than that of the second heat sink 227, and the position of the top surface of the first heat sink 221 is lower than the position of the top surface of the second heat sink 227, and the position of the bottom surface of the first heat sink 221 is higher than the position of the bottom surface of the second heat sink 227. As such, there is a larger gap between the top surface of the first heat sink 221 and the top surface of the chassis 3, and between the bottom surface of the first heat sink 221 and the bottom surface of the chassis 3, so that the heat on the first heat sink 221 is more easily taken away, and the temperatures on both sides of the hash board 21 are more balanced.

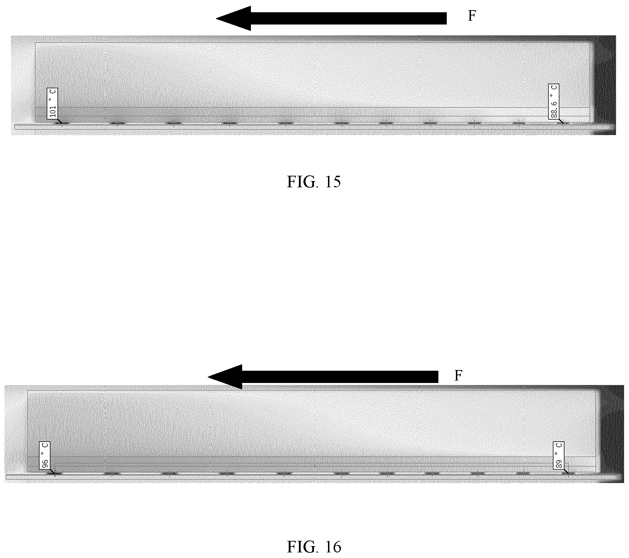

With reference to FIG. 15 and FIG. 16, FIG. 15 directly employs a solution that the first heat sink 221 is fixed on a side of the hash board 21, the heat of hash board 21 is directly dissipated using the first heat sink 221 (in actual products, a thermally conductive material may be provided between the first heat sink 221 and the hash board 21), and it is obtained from a simulation test that a temperature of the chips of the hash assembly 21 close to the air inlet (the air ingress direction is F) is 88.6°C, and a temperature of chips closes to the air outlet is 101°C. In FIG. 16, the hash board 21 uses the heat dissipation solution of the present application to dissipate heat, that is, a side of the hash board 21 is provided with the base plate 223 and the first heat sink 221, the hash board 21 directly contacts raised strips 2233 on the base plate 223, and the hash board 21 conducts heat and dissipates heat through the base plate 223 in which the heat spreaders 225 are embedded and the first heat sink 221. It is obtained from a simulation test that the temperature of the chips of the hash board 21 close to the air inlet (the air ingress direction is F) is 89°C, and the temperature of the chips close to the air outlet is 96°C. It can be seen that the heat dissipation effect of the heat dissipation solution provided in the present application is significantly better.

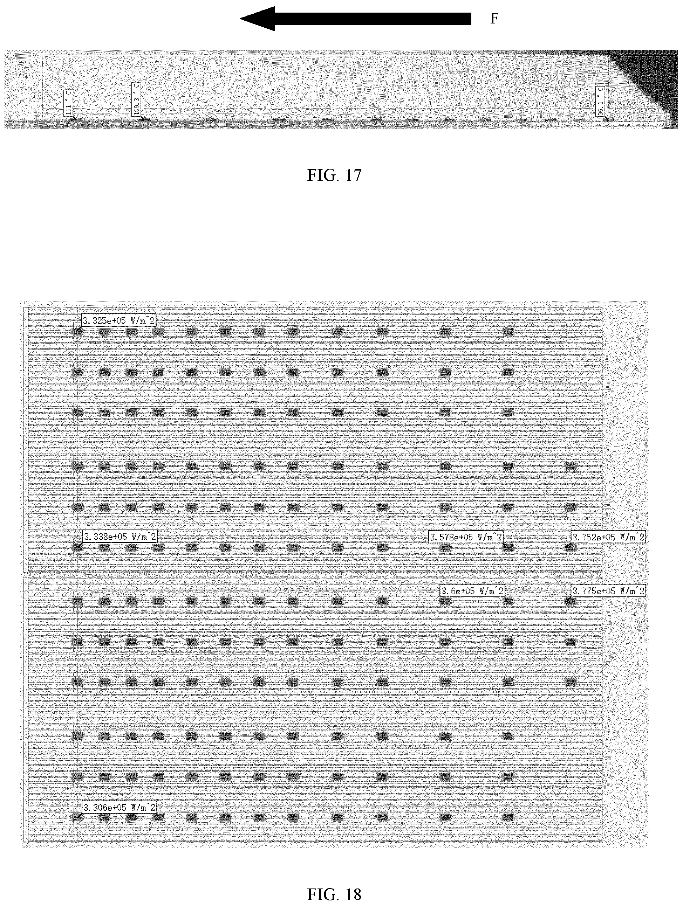

The first heat dissipation solution is employed in FIG. 17 and FIG. 18: the base plate 223 is disposed between the hash board 21 and the first heat sink 221, the hash board 21 conducts heat and dissipates heat through the base plate 223 and the first heat sink 221, the heat pipes are embedded in the surface of the base plate 223 close to the hash board 21, and the heat pipes directly contact the chips via the thermally conductive silicone. It is obtained from a simulation test that the temperature of the chips on the hash board 21 close to the air inlet (the air ingress direction is F) is 99.1°C, and the temperatures of chips close to the air outlet are 109.3°C and 111°C. The heat flux density on the surfaces of the heat pipes is up to 37+W/cm².

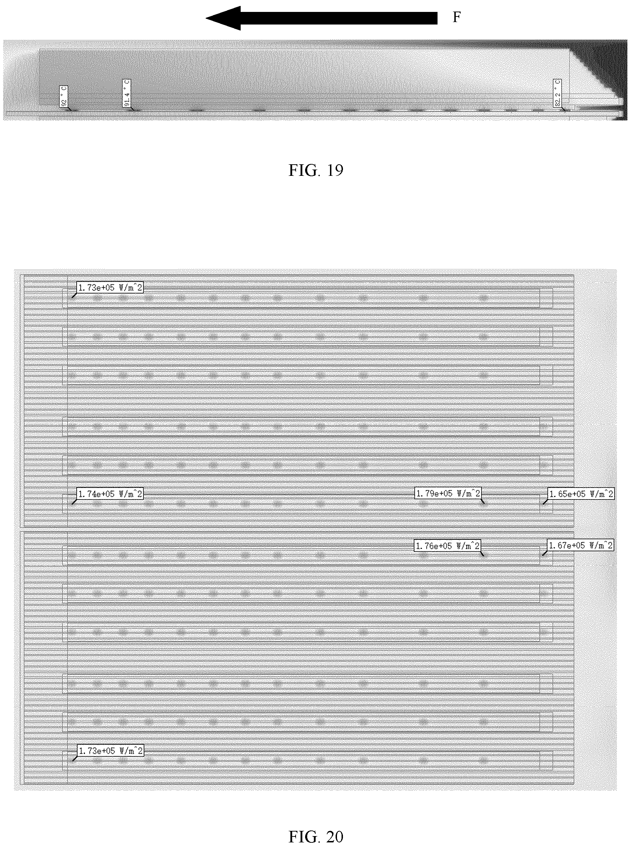

The second heat dissipation solution (namely, the heat dissipation solution in the present application) is employed in FIG. 19 and FIG. 20: the base plate 223 is disposed between the hash board 21 and the first heat sink 221, the hash board 21 conducts heat and dissipates heat through the base plate 223 and the first heat sink 221, the heat pipes are embedded in the surface of the base plate 223 away from the hash board 21, and the base plate 223 directly contacts the chips through the raised strips 2233 disposed on the surface. It is obtained from a simulation test that the temperature of the chips on the hash board 21 close to the air inlet (the air ingress direction is F) is 82.2°C, and the temperatures of chips close to the air outlet are 91.4°C and 92°C. The maximum heat flux density on the surfaces of the heat pipes is 17.9W/cm². There is a lower risk that the dry burning of the heat pipes causes the temperature-spreading effect to become poor.

It may be known from the simulation data that according to the solution of the present application, the effect of dissipating the heat of chips is better, the heat flux density of the surfaces of the heat pies drops to approach 20W/cm², and there is a substantially-reduced risk that the dry burning of the cooling medium in the heat pipes causes the temperature-spreading effect to become poor.

Those skilled in the art can appreciate that the above-described preferred solutions may be freely combined and superimposed without conflict.

It should be appreciated that the above-described embodiments are merely exemplary rather than limiting, and that various obvious or equivalent modifications to and substitutes for the above-described details made by those skilled in the art without departing from the basic principles of the present invention, are all included within the scope of the appended claims of the present invention.

## Claims

1. A hash assembly, comprising a hash board and a heat dissipation assembly fixedly connected to the hash board, one end of the hash board being an air ingress end and the other opposite end of the hash board being an air egress end, and a heat dissipation channel being formed between the air ingress end and the air egress end; wherein a surface of the hash board is provided with a plurality of chip columns, each of the chip columns comprises a plurality of chips arranged in a direction of the heat dissipation channel, and the chips in each of the chip columns are arranged from the air ingress end to the air egress end in a dense-to-sparse manner;
the heat dissipation assembly comprises at least one first heat sink and a base plate, the base plate has first surface and second surface opposite to each other, the first heat sink is in direct contact with the first surface, and the hash board is in direct contact with the second surface;
the heat dissipation assembly further comprises a plurality of heat spreaders which are embedded in the base plate at a side of the base plate away from the hash board, and positions and number of the heat spreaders all correspond one to one with those of the chip columns.

2. The hash assembly according to claim 1, wherein the heat spreaders are heat pipes, a plurality of mutually independent receiving grooves are provided on the first surface of the base plate, and the heat spreaders are fixed in the receiving grooves; positions and number of the receiving grooves all correspond one to one with those of the chip columns;
the base plate is fixed with the first heat sink by soldering;
the heat spreaders are fixed in the receiving grooves by a solder; a surface of the heat spreader close to the first heat sink is flush with the first surface; or the surface of the heat spreader close to the first heat sink is lower than the first surface, and a surface of the solder in the receiving groove is flush with the first surface.

3. The hash assembly according to claim 1, wherein a plurality of raised strips are provided on a side of the base plate close to the hash board;
a surface of the raised strip close to the hash board is formed as the second surface, and the chips on the hash board directly contact the second surface and/or contact the second surface via a thermally conductive material;
a height difference of the second surface is less than 0.1 mm;
the thermally conductive material is one or more of a thermally conductive silicone grease, a thermally conductive gel or a thermally conductive pad.

4. The hash assembly according to claim 3, wherein the hash assembly comprises a fixing member, a spring and a locking member, one end of the fixing member running through the spring, the first heat sink, the base plate and the hash board and being locked with the locking member;
between adjacent ones of the raised stripes runs through at least one said fixing member.

5. The hash assembly according to claim 1, wherein the first heat sink comprises a first plate body and first fins extending in a heat dissipation and ventilation direction, the first fins being arranged at equal intervals and fixedly connected to a surface of the first plate body, the base plate being fixed on the other surface of the first plate body;
the first fin comprise a first fin segment and a second fin segment integrally connected in the direction of the heat dissipation channel, a distance between an end of the first fin segment away from the first plate body and the first plate body gradually increasing in a direction from the air inlet to the air outlet; a distance between an end of the second fin segment away from the first plate body and the first plate body is constant, and the distance is equal to a maximum distance between the end of the first fin segment away from the first plate body and the first plate body;
there are no said chips in a vertical projection region of a region occupied by the first fin segment on the hash board.

6. The hash assembly according to claim 5, wherein an end of the first fin segment away from the first plate body is an inclined surface which is inclined at an angle in a range of 30°-60° with respect to the first plate body; a minimum distance between the end of the first fin segment away from the first plate body and the first plate body is 0.

7. The hash assembly according to claim 1, wherein the hash assembly further comprises a second heat sink secured to a surface of the hash board away from the first heat sink;
positions of top surfaces of the first heat sink and the second heat sink are lower than a position of the top surface of the hash board, and positions of bottom surfaces of the first heat sink and the second heat sink are higher than a position of the bottom surface of the hash board.

8. The hash assembly according to claim 7, wherein the hash assembly further comprises a second heat sink, the second heat sink comprises a second plate body and second fins extending in the heat dissipation and ventilation direction, the second fins being arranged at equal intervals and fixedly connected to a surface of the second plate body, and the hash board being fixed on the other surface of the second plate body;
the second fin comprises a first fin section and a second fin section integrally connected in the direction of the heat dissipation channel, a distance between an end of the first fin section away from the second plate body and the second plate body gradually increasing in the direction from the air inlet to the air outlet; a distance between an end of the second fin section away from the second plate body and the second plate body is constant, and the distance is equal to a maximum distance between the end of the first fin section away from the second plate body and the second plate body;
there are no said chips in a region of the hash board corresponding to the first fin section.

9. The hash assembly according to claim 2, wherein the heat spreader is a heat pipe, and is a plate-shaped body formed by flatting a cylindrical heat pipe which is placed in a receiving groove provided on the base plate;
the heat transferred from a maximum temperature to a minimum temperature of the heat spreader Qmax≥30W; when the heat is Qmax, a temperature difference ΔT between an evaporation end and a condensation end is ΔT ≤3°C.

10. An air-cooled server, wherein the air-cooled server comprises a chassis and the hash assembly according to any of claims 1-9, the hash assembly being received in the chassis.

11. The air-cooled server according to claim 10, wherein a sliding groove is disposed on a top and a bottom of the chassis, respectively, and the fixing and sliding of the hash assembly in the chassis is achieved in a way that the top and bottom of the hash board are engaged in the sliding grooves;
a distance between adjacent said hash assemblies is greater than 2 mm; a gap exists between the top surface and bottom surface of the first heat sink and the top surface and bottom surface of the chassis, respectively.
